# EUROPEAN PATENT APPLICATION

(11) **EP 3 069 853 A1**
(43) Date of publication of application: **21.09.2016**
(21) Application number: 14862690.6
(22) Date of filing: 27.10.2014
(51) Int. Cl.: B29C 67/00, C23C 14/00

(54) **MIXED THREE-DIMENSIONAL MOLDING METHOD FOR MULTI-COMPONENT MATERIAL**

(30) Priority: 15.11.2013 CN 201310568235
(71) Applicant: Li, Changhai, Weihai, Shandong 264200 (CN); Huang, Meixiang, Weihai, Shandong 264200 (CN); Li, Ruoning, Weihai, Shandong 264200 (CN)
(72) Inventor: Li, Changhai, Weihai, Shandong 264200 (CN); Huang, Meixiang, Weihai, Shandong 264200 (CN); Li, Ruoning, Weihai, Shandong 264200 (CN)
(74) Representative: Negrini, Elena
(86) International application number: PCT/CN2014/000947
(87) International publication number: WO 2015/070516

(57) **Abstract**

The present invention relates the technology field of quick molding, and particularly, to a mixed three-dimensional molding method for a multi-component material. The method is characterized by comprising following steps: preparing a substrate and a group of multi-component materials; machining the substrate; manufacturing a lamination body, machining the lamination body; housing the obtained lamination machined body in a sealed elastic sleeve; vacuuming the elastic sleeve, vacuuming the elastic sleeve to form a vacuum state in the elastic sleeve; performing injection molding.

The present invention also provides a method for implementing a mixed three-dimensional image of the multi-component material by controlling displacement paths of various colors, and the method requires a simple process, has a wide use range range, a high accuracy and a high speed, and needs low costs.

## Description

### DESCRIPTION

### TECHNICAL FIELD

The present invention relates a rapid molding technology field, and more particularly, to a mixed three-dimensional molding method for a multi-component material by controlling a moving path of the multi-component material.

### BACKGROUND ART

Generally, in a rapid molding technology field, researches of a mixed three-dimensional molding process for a multi-component material still stay in the early stages and thus, performance is not large. Uniquely, an executing method is known as a laser engineered net shaping (LENS) method. In the LENS, the material power is blown by a high-power laser beam, the powder misaligned with the laser beam drops at one side, and powder meeting the laser spot is melted to be coupled with the surface of the elongated part. Accordingly, when the laser spot blows the powder having more nozzles to the scanning part, the component is sticking layer by layer to be gradually elongated. The LENS method may implement the mixed three-dimensional molding of the multi-component material powder, but the elongating process implements spots by a unit. Thus, like the existing rapid molding techniques, a limitation relationship between the precision and the speed, which cannot be overcome, occurs. As a result, the speed and the precision may not be increased to a desired level and there is a limitation in the material use by using a laser melting technique and cost is high.

### SUMMARY OF INVENTION

An object of the present invention is to provide a mixed three-dimensional molding method for a multi-component material by controlling a moving path of the multi-component material, in which disadvantages in the related art are overcome, a process is simple, an application range is wide, precision is high, a speed is rapid, and processing is convenient.

The present invention can be carried out by the following steps.

An aspect of the present invention provides a mixed three-dimensional molding method for a multi-component material, comprising:
- step 1 of preparing a substrate and a group of multi-component material;
- step 2 of preparing a substrate processing surface to be used by processing the substrate;
- step 3 of preparing a laminate, forming the laminate on the substrate processing surface by preparing the multi-component materials as unit layers one by one, and forming the laminate by laminating at least two unit layers;
- step 4 of processing the laminate, performing a three-dimensional cutting process in a cross section of the top layer of the laminate according to a design requirement, and reaching each point of the cross section of the laminate after processing in the unit material layer designated according to the design requirement to obtain a laminate processing body;
- step 5 of covering the obtained laminate processing body in a sealed elastic sleeve and performing vacuum pumping in the elastic sleeve to make the inside of the elastic sleeve be in a vacuum state, in which the pressure is smaller than 0.1 MPa; and
- step 6 of performing compressive molding, putting the elastic sleeve in the vacuum state covered in the laminate processing body in a rigid mold, and obtaining a mixed three-dimensional molding body by compressively deforming the laminate processing body by using rigid pressure or equal pressure.

The present invention can be also carried out by the following steps.

Another aspect of the present invention provides a mixed three-dimensional molding method for a multi-component material, comprising:
- step 1 of preparing a substrate and a group of multi-component material;
- step 2 of obtaining a bottle-shaped processing surface having an opening by processing the substrate;
- step 3 of preparing a laminate, preparing multi-component materials as unit layers on the bottle-shaped processing surface (an inner surface and an outer surface) having the opening one by one to form a bottle-shaped laminate having the opening, and forming the laminate by laminating at least two unit layers;
- step 4 of processing the laminate, performing a three-dimensional cutting process in a cross section of the laminate according to a design requirement, and reaching each point of the cross section of the laminate after processing in the unit material layer designated according to the design requirement to obtain a bottle-shaped laminate processing body having the opening;
- step 5 of covering the obtained bottle-shaped laminate processing body having the opening in a sealed elastic sleeve and performing vacuum pumping in the elastic sleeve to make the inside of the elastic sleeve be in a vacuum state, in which the pressure is smaller than 0.1 MPa; and
- step 6 of performing injection molding, putting the elastic sleeve in the vacuum state covered in the laminate processing body in a bottle-shaped rigid mold having an opening, injecting high-pressure gas or liquid into the rigid mold at an opening point of the bottle-shaped rigid mold having the opening, deforming a laminate processing body by applying pressure to the laminate processing body by the high-pressure gas or liquid through the wall of the elastic sleeve, moving a processing surface of the laminate processing body to the top of the wall of the rigid mold, generating a corresponding change even in a distribution in the laminate processing body, and obtaining a new distribution of the multi-component material suitable for the design requirement to obtain a mixed three-dimensional molding body, in which the pressure range of the gas or liquid is 0.1 to 630 MPa.

The present invention can carried out by the following steps.

Yet another aspect of the present invention provides a mixed three-dimensional molding method for a multi-component material, comprising:
- step 1 of preparing a substrate and a group of multi-component material;
- step 2 of obtaining a flat plate processing surface by processing the substrate;
- step 3 of preparing a laminate, forming the laminate on the flat plate substrate processing surface by preparing the multi-component materials as unit layers one by one, and forming the laminate by laminating at least two unit layers;
- step 4 of processing the laminate, performing a three-dimensional cutting process in a cross section of the laminate according to a design requirement, and reaching each point of the cross section of the laminate after processing in the unit material layer designated according to the design requirement to obtain a laminate processing body;
- step 5 of performing melting deformation, putting the laminate processing body horizontally in a rigid mold of which the bottom is a horizontal plane, gradually softening the multi-component material by heating in a hot finance, generating deformation under gravity and surface tension, and moving the laminate processing surface to the horizontal plane to obtain a mixed three-dimensional molding body.

The present invention can be carried out by the following steps.

Still another aspect of the present invention provides a mixed three-dimensional molding method for a multi-component material, comprising:
- step 1 of preparing a substrate and a group of multi-component material;
- step 2 of performing a three-dimensional cutting process on a substrate working surface by processing the substrate and setting a depth of each point of the substrate processing surface after processing to be suitable for a design required depth;
- step 3 of preparing a laminate, forming the laminate on the substrate processing surface by preparing unit layers one by one, and forming the laminate by laminating at least two unit layers; and
- step 4 of processing the laminate and performing a cutting process of the laminate along a cross section parallel with the substrate working surface to obtain a mixed three-dimensional molding body.

A multi-component material constituted by the flat plate surface processing surface having the same size as a known photograph based on the known photograph and a material in which a group of colors is gradually changed may be prepared, the laminate may be formed by preparing unit layers one by one on the flat plate surface processing surface in order of the gradually changed colors, the cutting process of the laminate may be performed according to a grayscale of the photograph, and a processing depth of each point of the cross section of the laminate may be proportional to a grayscale value of the corresponding point in the photograph.

A multi-component material constituted by the flat plate surface processing surface having the same size as a known photograph based on the known photograph and a material in which a group of colors is gradually changed may be prepared, a cutting process may be performed on the substrate working surface again, a processing depth of each point may be proportional to a grayscale value of the corresponding point in a known photograph, and the laminate may be formed by preparing unit layers one by one on the flat plate surface processing surface in order of the gradually changed colors.

The material of the unit layer may use powder, a particle size may not be larger than 0.1 mm, and the thickness of each unit layer may be uniform.

The unit layers may be laminated as the laminate one by one by using thin materials having a uniform thickness and a thickness of the unit layer may not be larger than 5 m.

In the unit layer, the material density in a normal direction of the substrate working surface may be equalized.

A laminating process of the multi-component material may generally use spraying, brushing, precipitating, adsorbing, or printing, and after a positive electrode plate and a target are prepared, unit layers may be prepared on the substrate processing surface or the unit layer surface thereon by using electroplating, magnetron sputtering, or vacuum depositing.

The material of the present invention may contain an adhesive, the adhesive may be a hot-melt adhesive or a water-soluble adhesive, and water may also be a specific adhesive. Herein, the reason for using the adhesive is to form a molding body as a preliminary molding body which is convenient to mechanical processing by enhancing adhesion between materials. The adhesive may be used as a lubricant (for example, a hot-melt adhesive), and may cause lubrication during hot-melting and it is beneficial to a modified molding.

In the present invention, if the multi-component material is a material having different colors, the mixed three-dimensional molding problem for the multi-component material may be actually converted into a three-dimensional imaging problem of various colors. Actually, the present invention provides a method for implementing a mixed three-dimensional image having various colors by controlling a moving path of various colors in which a process is simple, the use range is wide, precision is high, a speed is rapid, and cost is low.

In the present invention, a technical limitation having the rapid molding technique in the related art is overcome by using a 'line' other than 'the point' as a molding unit, a technical problem of a limitative relationship between precision and speed of the rapid molding technique is solved, the processing speed and the processing precision are largely enhanced, and the mixed three-dimensional molding of the multi-component material having a large size (thickness) is completed one-offs. In the present invention, a limitation for the material is very small and the present invention may be applied to almost all of powder materials and members.

### BRIEF DESCRIPTION OF DRAWINGS

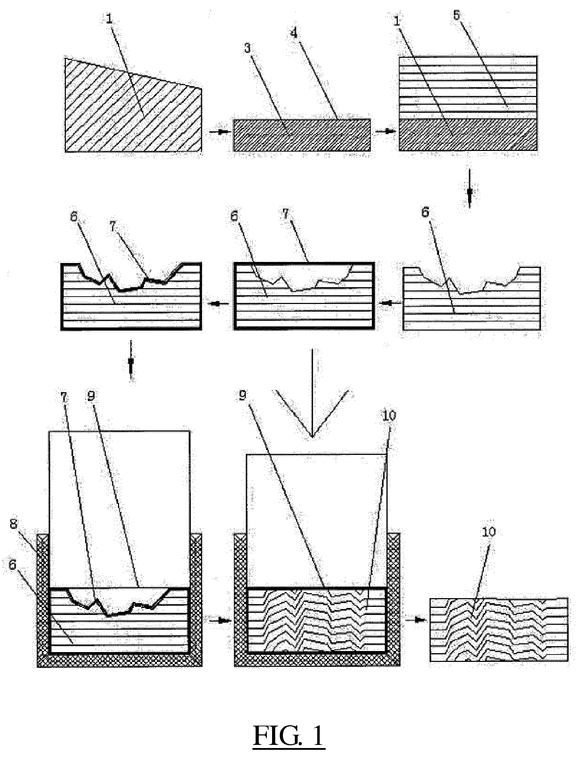

- Figure 1 shows an explanatory diagram of a first process according to the present invention.

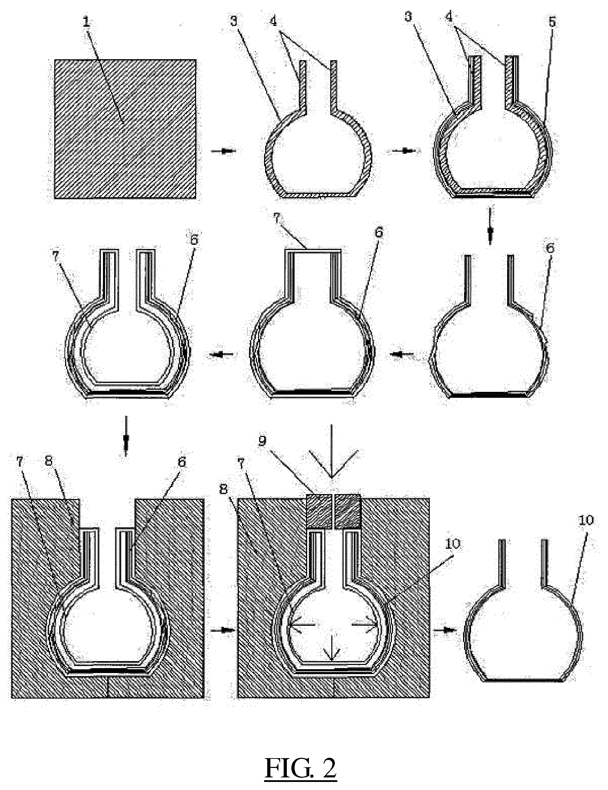

- Figure 2 shows an explanatory diagram of a second process according to the present invention.

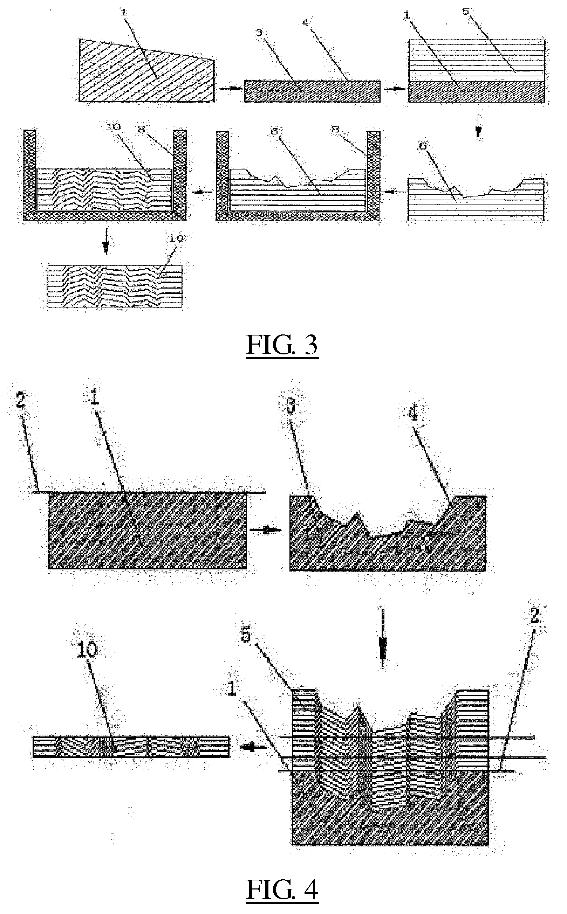

- Figure 3 is an explanatory diagram of a third process according to the present invention.
- Figure 4 is an explanatory diagram of a fourth process according to the present invention.

### BEST MODE FOR CARRYING OUT THE INVENTION

Hereinafter, the present invention will be described in more detail with reference to the accompanying drawings.

A mixed three-dimensional molding method for a multi-component material includes the following steps.
- Step 1: A substrate 1 and a multi-component material group of one group containing an adhesive are prepared. The substrate 1 may be a flat surface or a curved surface, the material may be a powder body having a particle size of larger than 0.1 mm or a plate member having a thickness of smaller than 5 m and generally larger than 5 mm, and the adhesive may be a hot-melt adhesive or a water-soluble adhesive, and water may also be a specific adhesive. Herein, the reason for using the adhesive is that a molding body is formed as a preliminary molding body which is convenient to mechanical processing by enhancing adhesion between materials. The adhesive may be used as a lubricant (for example, a hot-melt adhesive), and may cause lubrication during melting and it is beneficial to a modified molding. Further, the adhesive may also not be used. For example, a laminate may be prepared by using a method such as electric plating and vacuum plating (including magnetron sputtering, vacuum deposition, and the like), but first, a positive electrode plate or a target needs to be provided by using the multi-component material.
- Step 2: A surface processing surface 4 is prepared to be obtained and used by processing the substrate 1.
- Step 3: A laminate 5 is prepared, the laminate 5 is formed by preparing unit layers on the surface processing surface 4 one by one, and the laminate 5 is formed by laminating at least two unit layers. The laminate 5 is prepared by using a process such as spraying, brushing, precipitating, adsorbing, printing, electroplating, magnetron sputtering, or vacuum deposition and formed by preparing multi-component unit layers on the surface processing surface 4 one by one. First, the unit layers are prepared, respectively, and then laminated again to mold the laminate 5. If the used adhesive is the hot-melt adhesive (for example, paraffin), after the preparing process is performed under a condition of a melting temperature of the adhesive, finally, the temperature drops to coagulate and mold the laminate 5. If the used adhesive is the water-soluble adhesive (for example, gelatinized starch), constant moisture is added to have viscosity, the laminate 5 is completed and then dried and molded, thicknesses of the unit layers may be uniform or not, and thicknesses of other unit layers may be the same or not.
- Step 4: The laminate 5 is processed, a three-dimensional cutting process is performed at a cross section of the laminate according to a design requirement, each point of the cross section of the laminate which is processed in depth according to the design requirement reaches the inside of the unit layer designated according to the design requirement to obtain a laminate processing body 6. The laminate 5 obtained in step 3 is connected with the substrate 1, but in a general situation, the laminate 5 is separated from the substrate 1 and then the processing is performed, and the separating method variously includes heating separation, cutting separation, or the like. Of course, the separation may be performed under a special situation, and for example, when the substrate is an elastic body and does not influence the progress of other steps, the cutting process of the laminate 5 may use various processes including carving, cutting, grinding, milling, grooving, sandblasting, and the like.
- Step 5: The obtained laminate processing body 6 is covered in a sealed elastic sleeve 7, and vacuum pumping is performed in the elastic sleeve 7 again to make the inside of the elastic sleeve 7 be in a vacuum state and make the pressure be smaller than 0.1 MPa. Herein, the reason for using the elastic sleeve 7 is to make the multi-component material move in a design direction by making the inside thereof be in the vacuum environment and compressing the surface of the laminate processing body 6 under external air pressure to prevent the relative movement between surface materials.
- Step 6: Compressed molding is performed, the elastic sleeve 7 in the vacuum state covered by the laminate processing body 6 is put in a rigid mold 8, and the laminate processing body 6 is compressively deformed by using rigid pressure or equal pressure. Actually, first, the laminate processing body 6 is put in the rigid mold 8, the rigid mold 8 with the laminate processing body 6 is covered by using the sealed elastic sleeve 7 again, vacuum pumping is performed in the elastic sleeve 7, and then, finally, the laminate processing body 6 is compressively deformed by using rigid pressure or equal pressure, and the pressed surface of the laminate processing body 6 is compressively deformed in full-face by a pressure surface 9 of a presser,
   in this case, under the double action of the pressure surface 9 of the presser and the vacuum state in the elastic sleeve 7, the surface of the laminate processing body 6 vertically ascends up to the top of the pressure surface 9 of the bottom of the presser, and a distribution in the laminate processing body 6 is changed to obtain a new three-dimensional distribution of the multi-component material satisfying the design requirement. Thus, a kind of mixed three-dimensional molding for multi-component material is completed and the processing surface of the laminate processing body 6 confronts with the surface of the mold 8 and the effect thereof is consistent. When the laminate processing body 6 is compressively deformed by using the equal pressure (air pressure or hydraulic pressure), the processing surface of the laminate processing body 6 confronts with the wall of the rigid mold 8, and the reason is that the applying surface of the equal pressure dose not forcibly change the shape of the processing surface of the laminate processing body 6 contacting the applying surface,
   when the processing surface of the laminate processing body 6 confronts with the wall of the rigid mold 8 and is compressively deformed, the wall of the rigid mold 8 which confronts with the processing surface of the laminate processing body 6 needs to be professionally processed according to the requirement. As described above, when the laminate processing body 6 is first put in the rigid mold 8 and the rigid mold 8 put with the laminate processing body 6 is covered by the sealed elastic sleeve 7 again, vacuum pumping is performed in the elastic sleeve 7 and then, finally, the laminate processing body 6 is compressively deformed by using rigid pressure or equal pressure, and herein, in the case of using the compressive deformation of the presser, the surface of the laminate processing body 6 needs to confront with the pressure surface 9 of the presser, in order to smoothly perform the compressive deformation, it may depend on properties of the adhesive or heating or moisturizing, but it is not necessary.
- Step 7: A molding body 10 is taken out and degreasing, solidification, or densification is performed if necessary to obtain the mixed three-dimensional molding body. When the multi-component material is a ceramic material, the completed article needs to be prepared through degreasing and sintering.

A mixed three-dimensional molding method for a multi-component material includes the following steps.
- Step 1: A substrate 1 and a multi-component material group of one group containing an adhesive are prepared. The material may be a powder body having a particle size of larger than 0.1 mm or a plate member having a thickness of smaller than 5 m. The adhesive may be a hot-melt adhesive or a water-soluble adhesive, and water may also be a specific adhesive. Herein, the reason for using the adhesive is that a molding body is formed as a preliminary molding body which is convenient to mechanical processing by enhancing adhesion between materials. The adhesive may also not be used. For example, a laminate may be prepared by using a method such as electric plating, vacuum plating (including magnetron sputtering, vacuum deposition, and the like). However, first, a positive electrode plate or a target needs to be provided by using the multi-component material through electric plating, vacuum plating (including magnetron sputtering, vacuum deposition, and the like), and the like.
- Step 2: The substrate 1 is processed, the substrate 1 is processed as a bottle-shaped processing surface 4 of the substrate having a opening of a bottle-shaped substrate processing body 3 having an opening, the bottle-shaped substrate 3 having the opening has an inner surface and an outer surface, and the bottle-shaped processing surface 4 of the substrate may be the outer surface or the inner surface.
- Step 3: A laminate 5 is prepared, and unit layers are prepared on the bottle-shaped substrate processing surface 4 (the inner surface or the outer surface) having the opening one by one to form the bottle-shaped laminate 5 having the opening, and the laminate is formed by laminating at least two unit layers,
   the bottle-shaped laminate 5 having the opening may be prepared by using spraying, brushing, precipitating, adsorbing, printing, electroplating, magnetron sputtering, or vacuum deposition. Further, unit layers of the multi-component material are prepared on the bottle-shaped substrate processing surface 4 having the opening one by one to immediately form the bottle-shaped laminate 5 having the opening. Further, the respective unit layers are first prepared and laminated to form the bottle-shaped laminate 5 having the opening. If the used adhesive is the hot-melt adhesive (for example, paraffin), after the preparing process is performed under a condition of a melting temperature of the adhesive, finally, the temperature drops to coagulate and mold the laminate 5. If the used adhesive is the water-soluble adhesive (for example, gelatinized starch), constant moisture is added to have viscosity, the laminate 5 is completed and then dried and molded, thicknesses of the unit layers may be uniform or not, and thicknesses of other unit layers may be the same or not.
- Step 4: The laminate 5 is processed, a three-dimensional cutting process is performed at a cross section of the laminate 5 according to a design requirement, each point of the cross section of the laminate 5 which is processed in depth according to the design requirement reaches the inside of the unit layer designated according to the design requirement to obtain a bottle-shaped laminate processing body 6 having the opening, and the laminate 5 obtained in step 3 is connected with the substrate 1. In a general situation, the laminate 5 is separated from the substrate 1 and then the processing is performed, and the separating method variously includes heating separation, cutting separation, or the like. Of course, the separation may be performed under a special situation, and for example, when the substrate is an elastic body and does not influence the progress of other steps, the cutting process of the laminate 5 may use various processes including carving, cutting, grinding, milling, grooving, sandblasting, and the like.
- Step 5: The obtained bottle-shaped laminate processing body 6 having the opening is covered in a sealed elastic sleeve 7, vacuum pumping is performed in the elastic sleeve 7 again to make the inside of the elastic sleeve 7 be in a vacuum state, and the pressure is smaller than 0.1 MPa,
   herein, the reason for using the elastic sleeve 7 is to prevent the relative movement between materials by making the inside thereof be in the vacuum environment and compressing the surface of the bottle-shaped laminate processing body 6 having the opening under external pressure.
- Step 6: Injection molding is performed, the elastic sleeve 7 in a vacuum state of the bottle-shaped laminate processing body 6 having the opening is put in a bottle-shaped rigid mold 8 having an opening, high-pressure gas or liquid is injected into the rigid mold 8 in an equal presser 9 at the opening of the rigid mold 8, and the high-pressure gas or liquid compressively deforms the bottle-shaped laminate processing body 6 having the opening by applying pressure to the bottle-shaped laminate processing body 6 having the opening through the wall of the elastic sleeve 7. A processing surface of the bottle-shaped laminate processing body 6 having the opening moves to the top of the wall of the rigid mold 8, a change corresponding to a distribution in the bottle-shaped laminate processing body 6 having the opening is generated to obtain a new distribution of the multi-component material satisfying the design requirement. Thus, a kind of mixed three-dimensional molding 10 for multi-component material is complete. A pressure range of the gas or liquid is 0.1 to 630 MPa, and while the outer surface of the bottle-shaped laminate processing body 6 having the opening at the top is processed, actually, the processing may be performed with respect to the inner surface of the bottle-shaped laminate processing body 6 having the opening. In the above situation, the outer surface is put in the bottle-shaped laminate processing body 6 having the opening by using the rigid mold 8 having the bottle shape (may be opened or closed), the outer surface is covered by the elastic sleeve 7 again and vacuum pumping is performed. The covered outer surface is put in a sealed rigid container and high-pressure liquid or gas is injected in the container to deform the bottle-shaped laminate processing body 6 having the opening. Herein, the inner surface of the bottle-shaped laminate processing body 6 having the opening moves to the top of the wall of the rigid mold 8, and a change corresponding to a distribution in the bottle-shaped laminate processing body 6 having the opening is generated to obtain a new distribution of the multi-component material satisfying the design requirement. Thus, a kind of mixed three-dimensional molding 10 for multi-component material may be completed.
- Step 7: A molding body 10 is taken out and degreasing, solidification, or densification is performed if necessary to obtain the mixed three-dimensional molding body. When the multi-component material is a ceramic material, the completed article needs to be prepared through degreasing and sintering.

A mixed three-dimensional molding method for a multi-component material includes the following steps.
- Step 1: A substrate 1 and a multi-component material group of one group containing an adhesive are prepared. The material may be a powder body having a particle size of larger than 0.1 mm or a plate member having a thickness of smaller than 5 m. The adhesive may be a hot-melt adhesive or a water-soluble adhesive, and water may also be a specific adhesive. Herein, the reason for using the adhesive is that a molding body is formed as a preliminary molding body which is convenient to mechanical processing by enhancing adhesion between materials. The adhesive may be used as a lubricant (for example, a hot-melt adhesive), and may cause lubrication during melting and it is beneficial to a modified molding. Further, the adhesive may also not be used. For example, a laminate may be prepared by using a method such as electric plating, vacuum plating (including magnetron sputtering, vacuum deposition, and the like). However, first, a positive electrode plate or a target needs to be provided by using the multi-component material through electric plating, vacuum plating (including magnetron sputtering, vacuum deposition, and the like), and the like.
- Step 2: A surface processing surface 4 is prepared to be obtained and used by processing the substrate 1.
- Step 3: A laminate 5 is prepared, the laminate 5 is formed by preparing unit layers on the substrate processing surface 4 one by one, and the laminate 5 is formed by laminating at least two unit layers. The laminate 5 is prepared by using a process such as spraying, brushing, precipitating, adsorbing, printing, electroplating, magnetron sputtering, or vacuum deposition and formed by preparing multi-component unit layers on the substrate processing surface 4 one by one. First, the unit layers are prepared, respectively, and then laminated again to mold the laminate 5. If the used adhesive is the hot-melt adhesive (for example, paraffin), after the preparing process is performed under a condition of a melting temperature of the adhesive, finally, the temperature drops to coagulate and mold the laminate 5. If the used adhesive is the water-soluble adhesive (for example, gelatinized starch), constant moisture is added to have viscosity, the laminate 5 is completed and then dried and molded, thicknesses of the unit layers may be uniform or not, and thicknesses of other unit layers may be the same or not.
- Step 4: The laminate 5 is processed, a three-dimensional cutting process is performed at a cross section of the laminate according to a design demand, each point of the cross section of the laminate which is processed in depth according to the design demand reaches the inside of the unit layer designated according to the design demand to obtain a laminate processing body 6. The laminate 5 obtained in step 3 is connected with the substrate 1, but in a general situation, the laminate 5 is separated from the substrate 1 and then the processing is performed, and the separating method variously includes heating separation, cutting separation, or the like. Of course, the separation may be performed under a special situation, and for example, when the substrate is an elastic body and does not influence the progress of other steps, the cutting process of the laminate 5 may use various processes including carving, cutting, grinding, milling, grooving, sandblasting, and the like.
- Step 5: Melting deformation is performed, the laminate processing body 6 is horizontally put in a rigid mold 8 of which the bottom is a horizontal plane and heated in a hot finance to be gradually softened. The deformation is generated by applying gravity and surface tension, the surface of the laminate processing body 6 vertically moves to the horizontal plane, the corresponding change is generated even in the distribution therein to obtain a new mixed three-dimensional distribution of a multi-component material and thus, mixed three-dimensional molding 10 for multi-component material may be completed. A value of the deformation temperature is larger than a minimum softening point of the multi-component material and the rigid mold 8 may use a plaster mold. It is advantageous that it is easy to separate the molding body from the mold, a processing surface of the laminate processing body 6 may be placed upward or downward, and the softening temperature of the multi-component material may vary. However, if the difference is large, the difference may influence synchronism of the softening, and thus, the multi-component material is selected from a material having a softening point as similar as possible. The heat deformation temperature is generated selected to be a minimum softening temperature (taking a minimum value among softening temperatures of the multi-component material) or more, but if the heat deformation temperature is very low, it is not preferred that deformation molding is interfered, and if the heat deformation temperature is very high, it is not preferred that relative stability between multi-component materials cannot be controlled. When the laminate processing body is processed at an appropriate temperature, the multi-component material is gradually softened, but the mold limits the movement in the horizontal direction. Accordingly, under triple application of atmospheric pressure, gravity, and surface tension of the material, while the multi-component material of the laminate processing body 6 moves, the deformation of the laminate processing body 6 is generated, and finally, the mixed three-dimensional molding 10 for the multi-component material may be obtained.
- Step 6: A molding body 10 is taken out and degreasing, solidification, or densification is performed if necessary to obtain the mixed three-dimensional molding body. When the multi-component material is a ceramic material, the completed article needs to be prepared through degreasing and sintering.

A mixed three-dimensional molding method for a multi-component material includes the following steps.
- Step 1: A substrate 1 and a multi-component material group of one group containing an adhesive are prepared. The material may be a powder body having a particle size of larger than 0.1 mm or a plate member having a thickness of smaller than 5mm. The adhesive may be a hot-melt adhesive or a water-soluble adhesive, and water may also be a specific adhesive. Herein, the reason for using the adhesive is that a molding body is formed as a preliminary molding body which is convenient to mechanical processing by enhancing adhesion between materials. The adhesive may be used as a lubricant (for example, a hot-melt adhesive), and may cause lubrication during melting and it is beneficial to a modified molding. Further, the adhesive may also not be used. For example, a laminate may be prepared by using a method such as electric plating, vacuum plating (including magnetron sputtering, vacuum deposition, and the like). However, first, a positive electrode plate or a target needs to be provided by using the multi-component material through electric plating, vacuum plating (including magnetron sputtering, vacuum deposition, and the like), and the like.
- Step 2: The substrate 1 is processed, cutting processing is performed on a substrate working surface 2, and the processing depth is suitable for a design required depth to obtain a substrate processing body 3 and a substrate surface 4. The cutting process of the substrate working surface 2 may use various processes including carving, cutting, grinding, milling, grooving, sandblasting, and the like.
- Step 3: A laminate 5 is prepared, the laminate 5 is formed by preparing unit layers on the substrate processing surface 4 one by one, and the laminate 5 is formed by laminating at least two unit layers. The laminate 5 is prepared by using a process such as spraying, brushing, precipitating, adsorbing, printing, electroplating, magnetron sputtering, or vacuum deposition and formed by preparing multi-component unit layers on the substrate processing surface 4 one by one. First, the unit layers are prepared, respectively, and then laminated again to mold the laminate 5. If the used adhesive is the hot-melt adhesive (for example, paraffin), after the preparing process is performed under a condition of a melting temperature of the adhesive, finally, the temperature drops to coagulate and mold the laminate 5. If the used adhesive is the water-soluble adhesive (for example, gelatinized starch), constant moisture is added to have viscosity, the laminate is completed and then dried and molded. The thicknesses of the unit layers may be uniform and the surface density in a normal direction of the substrate processing surface 4 of each unit layer may be equalized. For example, in a plate-shaped substrate processing body 3 of hadona, powder is uniformly sprayed by using a parallel sprayer in a vertical direction to the substrate working surface 2 to prepare the laminate 5, and in the unit layers, the surface density in the normal direction of the substrate working surface 2 is equalized. When the surface density in the normal direction of the substrate working surface 2 of each unit layer is equalized, the precision of the molding body may be enhanced, and thicknesses of other unit layers may be the same as or different from each other.
- Step 4: A laminate 5 is processed, and cutting processing is performed in the laminate 5 along a cross section parallel with the substrate working surface 2. In addition, a three-dimensional distribution of the multi-component material suitable for the design requirement is obtained and a kind of mixed three-dimensional molding 10 of the multi-component material is obtained. After completing Step 3, since the multi-component material is mixed in advance in the cross section parallel with the substrate working surface of the laminate 5, the cutting process is performed in the laminate along the cross section parallel with the substrate working surface to obtain a new mixed three-dimensional molding body of one multi-component material.
- Step 5: A molding body 10 is taken out and degreasing, solidification, or densification is performed if necessary to obtain the mixed three-dimensional molding body. When the multi-component material is a ceramic material, the completed article needs to be prepared through degreasing and sintering. Herein, in the required description, in the present invention, if the multi-component material is a material having different colors, the mixed three-dimensional molding problem for the multi-component material may be actually converted into a three-dimensional imaging problem of various colors. Actually, the present invention also provides a method for implementing a mixed three-dimensional image having various colors by controlling a moving path of various colors in which a process is simple, the use range is wide, precision is high, a speed is rapid, and cost is low.

### EXAMPLE 1

First, a sheet of flat black-and-white photograph is prepared and used as one ceramic art object to have the same pattern as a known photograph, that is, a three-dimensional imaging ceramic art object of a sheet of flat photograph in each parallel cross section in a designed direction.
- Step 1: A plaster plate (having a thickness of 10 mm) having the same size as the flat photograph is prepared as a substrate, ceramic powder having two colors of pure white and pure gray is selected, and the particle size range thereof is 100 to 260 meshes. Ceramic powder having two colors of white and black is mixed to prepare a gradient color of white and black, and the ratios thereof are 1:99, 2:98, ......, 98:2, and 99:1, respectively. Powders for multi-component materials which are gradually changed from white to black are obtained to be displayed as w1, w2, ......, w99, and w100. Paraffin powder is selected as an adhesive and mixed with the ceramic powder (a weight ratio of paraffin is 30%) to obtain ceramic powder having a gradient color which is changed from white to black of one group mixed with paraffin.
- Step 2: Cutting processing is performed to the plaster plate substrate by using a cutter to make a processing depth of each surface point of the plaster plate substrate to A=H*K. Herein, H is a thickness of the plaster plate, K is a grayscale value of a corresponding point of the photograph, a grayscale of pure white is 0%, a grayscale of black is 100%, and a grayscale of any color is between 0 and 1. To this end, a plaster plate substrate having an uneven surface is obtained.
- Step 3: The adhesive is dissolved by heating the powders w1, w2, ......, w99, and w100 up to 80°C, spraying is performed by using a spray gun, the spraying method is performed on the uneven surface of the plaster plate substrate in order of w1, w2, ......, w99, and w100, a direction of the spray gun is maintained vertically to the plaster plate at all times, and a spraying amount needs to be uniform. Thus, laminates w1, w2, ......, w99, and w100 are formed on a processing surface of the plaster plate substrate by the method.
- Step 4: The same kind of powder bodies are distributed on another plane parallel with the substrate due to the uneven plane in which the plaster plate substrate is processed. In the processing method of the plaster plate substrate, as described above, since a grayscale value of each point of a cross-sectional plane of the laminate parallel with the substrate is proportional to a grayscale value of a corresponding point of the known photograph, the same image as the known photograph is expressed in the cross-sectional plane of the laminate parallel with the substrate, and merely, the brightness of another cross-sectional photograph is different. A three-dimensional image of the known flat photograph is obtained by the method. This is a mixed three-dimensional molding derived from materials of the multi-component powders w1, w2......w99, and w100.
- Step 5: Finally, degreasing and sintering are performed in the molding body to obtain a three-dimensional imaging ceramic art object of the known flat photograph.

### EXAMPLE 2

First, a sheet of flat black-and-white photograph is prepared and used as one ceramic art object to have the same pattern as a pre-known photograph, that is, a three-dimensional imaging ceramic art object of a sheet of flat photograph in each parallel cross section in a designed direction.
- Step 1: A gypsum plate (having a thickness of 10 mm) having the same size as the flat photograph is prepared as a substrate, ceramic powder having two colors of pure white and pure gray is selected, and the particle size range thereof is 100 to 260 meshes. Ceramic powder having two colors of white and black is mixed to prepare a gradient color of white and black, and the ratios thereof are 1:99, 2:98, ......, 98:2, and 99:1, respectively. The powders are displayed as w1, w2, ......, w99, and w100, respectively. Gelatinized starch is selected as an adhesive and mixed with the ceramic powder (a weight ratio of gelatinized starch is 0.2%) to obtain a ceramic powder slurry having a gradient color which is changed from white to black of one group mixed with gelatinized starch.
- Step 2: In the powder scurries w1, w2......w99, and w100, spraying is performed by using a spray gun and the spraying method is uniformly performed on the surface of the plaster plate substrate in order of w1, w2, ......, w99, and w100, and laminates w1, w2......w99, and w100 are formed, dried, and molded on the plaster plate substrate by the method. Cutting processing is performed to the plaster plate substrate by using a cutter to make a processing depth of each surface point of the plaster plate substrate to A=H*K. Herein, H is a thickness of the plaster plate and K is a grayscale value of a corresponding point of the photograph. A grayscale of the laminate processing body obtained above is represented by percentage, a grayscale of pure white is 0%, a grayscale of black is 100%, and a grayscale of any color is between 0 and 1. As described in the processing method of the laminate, the same image as the known photograph is expressed on the processing surface of the laminate.
- Step 3: After the obtained laminate is covered in the sealed elastic sleeve, vacuum pumping is performed in the elastic sleeve to make the inside of the elastic sleeve be in a vacuum state, and the pressure be 0.01 MPa.
- Step 4: The elastic sleeve in the vacuum state covered by the laminate processing body is put in a stainless mold, the laminated processing surface is placed upward, the pressure is prepared by using a presser having a planar pressure surface, the pressure is 100 MPa, the laminate processing body is deformed under the application of the presser and the laminate processing surface ascends up to the pressure surface. In addition, the same image as the known photograph is expressed on the pressure surface and a change is generated even in the inside of the laminate to obtain a mixed three-dimensional molding derived from the multi-component materials w1, w2......w99, and w100.
- Step 5: Finally, degreasing and sintering are performed in the molding body to obtain a three-dimensional imaging ceramic art object of the known flat photograph.

## Claims

1. A mixed three-dimensional molding method for a multi-component material comprising the following steps:
- step 1 of preparing a substrate and a group of multi-component materials;
- step 2 of preparing a substrate processing surface to be used by processing the substrate;
- step 3 of preparing a laminate, forming the laminate on the substrate processing surface by preparing the multi-component materials as unit layers one by one, and forming the laminate by laminating at least two unit layers;
- step 4 of processing the laminate, performing a three-dimensional cutting process in a cross section of the top layer of the laminate according to a design requirement, and reaching each point of the cross section of the laminate after processing in the unit material layer designated according to the design requirement to obtain a laminate processing body;
- step 5 of covering the obtained laminate processing body in a sealed elastic sleeve and performing vacuum pumping in the elastic sleeve to make the inside of the elastic sleeve be in a vacuum state; and
- step 6 of performing compressive molding, putting the elastic sleeve in the vacuum state covered in the laminate processing body in a rigid mold, and obtaining a mixed three-dimensional molding body by compressively deforming the laminate processing body by using rigid pressure or equal pressure.

2. A mixed three-dimensional molding method for a multi-component material comprising the following steps:
- step 1 of preparing a substrate and a group of multi-component material;
- step 2 of obtaining a bottle-shaped processing surface having an opening by processing the substrate;
- step 3 of preparing a laminate, preparing multi-component materials as unit layers on the bottle-shaped substrate surface having the opening one by one to form a bottle-shaped laminate having the opening, and forming the laminate by laminating at least two unit layers;
- step 4 of processing the laminate, performing a three-dimensional cutting process in a cross section of the laminate according to a design requirement, and reaching each point of the cross section of the laminate after processing in the unit material layer designated according to the design requirement to obtain a bottle-shaped laminate processing body having the opening;
- step 5 of covering the obtained bottle-shaped laminate processing body having the opening in a sealed elastic sleeve and performing vacuum pumping in the elastic sleeve to make the inside of the elastic sleeve be in a vacuum state; and
- step 6 of performing injection molding, putting the elastic sleeve in the vacuum state covered in the laminate processing body in a bottle-shaped rigid mold having an opening, injecting high-pressure gas or liquid into the rigid mold at an opening point of the bottle-shaped rigid mold having the opening, deforming a laminate processing body by applying pressure to the laminate processing body by the high-pressure gas or liquid through the wall of the elastic sleeve, moving a processing surface of the laminate processing body to the top of the wall of the rigid mold, generating a corresponding change even in a distribution in the laminate processing body, and obtaining a new distribution of the multi-component material suitable for the design requirement to obtain a mixed three-dimensional molding body.

3. A mixed three-dimensional molding method for a multi-component material comprising the following steps:
- step 1 of preparing a substrate and a group of multi-component material;
- step 2 of obtaining a flat plate processing surface by processing the substrate;
- step 3 of preparing a laminate, forming the laminate on the flat plate substrate processing surface by preparing the multi-component materials as unit layers one by one, and forming the laminate by laminating at least two unit layers;
- step 4 of processing the laminate, performing a three-dimensional cutting process in a cross section of the laminate according to a design requirement, and reaching each point of the cross section of the laminate after processing in the unit material layer designated according to the design requirement to obtain a laminate processing body; and
- step 5 of performing melting deformation, putting the laminate processing body horizontally in a rigid mold of which the bottom is a horizontal plane, gradually softening the multi-component material by heating in a hot finance, generating deformation under gravity and surface tension, and moving the laminate processing surface to the horizontal plane to obtain a mixed three-dimensional molding body.

4. A mixed three-dimensional molding method for a multi-component material comprising the following steps:
- step 1 of preparing a substrate and a group of multi-component material;
- step 2 of performing a three-dimensional cutting process on a substrate working surface by processing the substrate and setting a depth of each point of the substrate processing surface after processing to be suitable for a design required depth;
- step 3 of preparing a laminate, forming the laminate on the substrate processing surface by preparing unit layers one by one, and forming the laminate by laminating at least two unit layers; and
- step 4 of processing the laminate and performing a cutting process along a cross section parallel with the substrate working surface to obtain a mixed three-dimensional molding body.

5. The mixed three-dimensional molding method according to any one of claims 1 to 3, wherein a multi-component material constituted by the flat plate substrate processing surface having the same size as a known photograph based on the known photograph and a material in which a group of colors is gradually changed is prepared, the laminate is formed by preparing unit layers one by one on the flat plate substrate processing surface in order of the gradually changed colors, the cutting process of the laminate is performed according to a grayscale of the photograph, and a processing depth of each point of the cross section of the laminate is proportional to a grayscale value of the corresponding point in the photograph.

6. The mixed three-dimensional molding method according to claim 4, wherein a multi-component material constituted by the flat plate substrate processing surface having the same size as a known photograph based on the known photograph and a material in which a group of colors is gradually changed is prepared, a cutting process is performed on the substrate working surface again, a processing depth of each point is proportional to a grayscale value of the corresponding point in a known photograph, and the laminate is formed by preparing unit layers one by one on the flat plate substrate processing surface in order of the gradually changed colors.

7. The mixed three-dimensional molding method according to any one of claims 1 to 6, wherein as the material of the unit layer, powder is used, a particle size is not larger than 0.1 mm, and the thickness of each unit layer is uniform.

8. The mixed three-dimensional molding method according to any one of claims 1 to 6, wherein the unit layers are laminated as the laminate one by one by using thin materials having a uniform thickness and a thickness of the unit layer is not larger than 5 m.

9. The mixed three-dimensional molding method according to claim 4, wherein in the unit layer, the material density in a normal direction of the substrate working surface is equalized.

10. The mixed three-dimensional molding method according to any one of claims 1 to 6, wherein a laminating process of the multi-component material uses spraying, brushing, precipitating, adsorbing, or printing.

11. The mixed three-dimensional molding method according to any one of claims 1 to 6, wherein after a positive electrode plate and a target are prepared by using the multi-component material, unit layers are prepared on the substrate processing surface or the unit layer surface thereon by using electroplating, magnetron sputtering, or vacuum depositing.
